Europäisches Patentamt

European Patent Office

Office européen des brevets

(19)

(11) Veröffentlichungsnummer: **0 315 834 B1**

## EUROPÄISCHE PATENTSCHRIFT

(12)

(12)

(45) Veröffentlichungstag der Patentschrift: **09.09.92**

(21) Anmeldenummer: **88117941.0**

(22) Anmeldetag: **27.10.88**

(51) Int. Cl.⁵: **G01R 22/00**

(54) **Zähleranordnung mit zwei Zweitarifzählern zur getrennten Erfassung des Stromverbrauchs von zwei Verbrauchergruppen.**

(30) Priorität: **10.11.87 DE 3738182**

(43) Veröffentlichungstag der Anmeldung:
**17.05.89 Patentblatt 89/20**

(45) Bekanntmachung des Hinweises auf die
Patenterteilung:
**09.09.92 Patentblatt 92/37**

(84) Benannte Vertragsstaaten:
**AT BE CH DE FR LI NL**

(56) Entgegenhaltungen:
**DE-A- 2 745 436**
**GB-A- 2 157 448**

**ERICSSON REVIEW, Band 62, Nr. 2, 1985,
Seiten 93-95, Stockholm. SE; H. BANG:
"Electronic electricity meter for differentiated tariffs"**

(73) Patentinhaber: **SIEMENS AKTIENGESELL-
SCHAFT
Wittelsbacherplatz 2
W-8000 München 2(DE)**

(72) Erfinder: **Steinmüller, Günter, Dipl.-Ing. FH
Laufamholzstrasse 65
W-8500 Nürnberg(DE)**

## Beschreibung

Die Erfindung betrifft eine Zähleranordnung mit zwei Zweitarifzählern zur getrennten Erfassung des Stromverbrauchs von zwei Verbrauchergruppen, wobei die zweite Verbrauchergruppe nur während einer ersten Tarifphase betrieben wird.

Der Fall, daß eine Verbrauchergruppe nur während einer Tarifphase betrieben wird, tritt z.B. in Haushaltungen bei elektrischen Speicherheizgeräten auf, die nur während der Niedertarifphase eingeschaltet werden. Bei einer Verbrauchsmessung mit einem Zweitarifzähler werden während der Niedertarifphase Heizgeräte und sonstige Verbraucher mit demselben Tarif verrechnet. Von vielen EVUs wird jedoch ein Sondertarif für Heizgeräte angeboten, der für die sonstigen Verbraucher nicht gelten sollte. Um eine getrennte Verbrauchserfassung der Heizgeräte zu ermöglichen, muß ein zweiter Zähler installiert werden. Für zwei Ferraris-Zähler ist in den bestehenden Anlagen jedoch oft kein ausreichender Platz vorhanden.

Das Platzproblem könnte durch Einsatz eines wesentlich kleineren elektronischen Zählers, mit dem z.B. nur die Heizkosten verrechnet werden, gelöst werden.

Elektronische Zähler müssen jedoch nach den derzeitigen Vorschriften jährlich überprüft werden, wenn nicht ein zweiter Zähler zu Kontrollzwecken vorhanden ist. In letzterem Fall erhöht sich die von der Physikalisch Technischen Bundesanstalt festgesetzte Einsatzdauer auf 10 Jahre.

Aufgabe der Erfindung ist es, eine Zähleranordnung so zu gestalten, daß sowohl eine getrennte Erfassung des Stromverbrauchs von zwei Verbrauchergruppen als auch eine Kontrolle der eingesetzten Zähler möglich ist.

Diese Aufgabe wird erfindungsgemäß dadurch gelöst, daß die erste Verbrauchergruppe über die Reihenschaltung beider Zweitarifzähler und die zweite Verbrauchergruppe nur über einen Zweitarifzähler mit dem Versorgungsnetz verbunden ist und daß durch Vergleich der Zählerstände der beiden Zweitarifzähler eine Funktionskontrolle der beiden Zweitarifzähler und durch Addition bzw. Subtraktion der Zählerstände eine getrennte Erfassung des Stromverbrauchs der beiden Verbrauchergruppen durchgeführt wird.

Mit dieser Schaltung wird die insbesondere für elektronische Elektrizitätszähler sehr wichtige Funktionskontrolle ermöglicht.

Ein Ausführungsbeispiel der Erfindung wird nachfolgend anhand der FIG näher erläutert.

Eine Verbrauchergruppe 4, die z.B. Heizgeräte darstellt, ist über einen ersten Zweittarifzähler 1 und einen Tarifschalter 5 an ein Stromnetz angeschlossen. Eine zweite Verbrauchergruppe 3, die alle sonstigen Verbraucher umfaßt, ist über die Reihenschaltung des ersten und zweiten Zweitarifzählers 1 an das Stromnetz angeschlossen. Die Tarifumschaltung in den Zweitarifzählern 1 und 2 sowie die Ansteuerung des Tarifschalters 5 erfolgt über einen Rundsteuerempfänger 6.

Der erste Zweitarifzähler 1, der vorteilhafterweise ein FerrarisZähler ist, weist ein erstes Zählwerk 1a für den Hochtarif und ein zweites Zählwerk 1b für den Niedertarif auf. Beim zweiten Zweitarifzähler 2, der z.B. als elektronischer Zähler ausgeführt ist, sind im Ausführungsbeispiel drei Zählwerke vorgesehen, wobei die beiden ersten - wie im folgenden erläutert - sowohl dem Hochtarif als auch dem Niedertarif zugeordnet sein können und ein drittes Zählwerk 2c zur Erfassung der Summe der beiden ersten Zählwerke 2a und 2b vorgesehen sein kann. Die Zählwerke 2a bis 2c müssen nicht notwendigerweise mit eigenen Anzeigevorrichtungen ausgestattet sein, sondern der Zählerstand kann auch auf einer Anzeige nacheinander abrufbar sein.

Bei dieser Zähleranordnung erfaßt der zweite Zweitarifzähler 2 nicht den Verbrauch der zweiten Verbrauchergruppe 4, also den Verbrauch an Heizenergie. Die Kontrolle des zweiten Zweitarifzählers 2, also des elektronischen Zählers, kann damit während des Hochtarifs mit dem ersten Zweitarifzähler, also dem Ferraris-Zähler erfolgen.

Dabei ergeben sich - je nach Zählweise der Zählwerke 2a, 2b - drei verschiedene Registrier- und Abrechnungsmöglichkeiten. Dabei wird im folgenden der Zählerstand jedes einzelnen Zählwerks durch ein "S" mit angefügtem Bezugszeichen des Zählwerks bezeichnet.

### 1. Fall 1:

Die Zählwerke 1a und 2a arbeiten nur im Hochtarif, die Zählwerke 1b und 2b arbeiten nur im Niedertarif.

Für Abrechnung und Kontrolle gelten dann:
Verbrauch der ersten Verbrauchergruppe 3 (sonstige Verbraucher) = $S2a + S2b$
Verbrauch der zweiten Verbrauchergruppe 4 (Heizgeräte) = $S1b - S2b$
Kontrolle: $S1a$ muß gleich $S2a$ sein, wenn die beiden Zweitarifzähler 1 und 2 in Ordnung sind.

### 2. Fall 2:

Die Zählwerke 1a, 2a und 2b arbeiten im Hochtarif.

Die Zählwerke 1b und 2a arbeiten im Niedertarif.

Für die Abrechnung und Kontrolle gelten dann:
Verbrauch der Verbrauchergruppe 3 (sonstige Verbraucher) = $S2a$
Verbrauch der zweiten Verbrauchergruppe 4 (Heizgeräte) = S1b - S2a + S2b
Kontrolle: Der Zählerstand S1a muß gleich dem Zählerstand S2b sein

3. Fall 3:

Die Zählwerke 1a und 2a arbeiten im Hochtarif, die Zählwerke 1b, 2a und 2b arbeiten im Niedertarif.

Für die Abrechnung und Kontrolle gelten dann: Verbrauch der Verbrauchergruppe 3 (sonstige Verbraucher) = S2a
Verbrauch der Verbrauchergruppe 4 (Heizgeräte) = S1b - S2b
Kontrolle: S1a = S2a - S2b, wenn beide Zweitarifzähler 1, 2 in Ordnung sind.

Die Abrechnung und Kontrolle wird vereinfacht, wenn der elektronische Elektrizitätszähler 2 eine dritte Anzeige 2c aufweist, die je nach Betriebsweise die Summe oder Differenz der Zählerstände der Zählwerke 2a und 2b anzeigt, da dann die Summe S2a + S2b bzw. Differenz S2a - S2b direkt zur Verfügung steht.

Dabei können in allen drei genannten Varianten nicht nur die Zähler überprüft werden, sondern der Verbrauch der zweiten Verbrauchergruppe (sonstige Verbraucher) 4 kann auch in der Nieder- und Hochtarifzeit getrennt erfaßt werden.

Bei der dargestellten Anordnung können auch beide Zweitarifzähler 1, 2 als Elektronikzähler ausgeführt sein, die sich dann gegenseitig überwachen. Eine solche Anordnung kann in einem Gehäuse untergebracht sein, wobei man auch eine einzige, auf die verschiedenen Zählwerke umschaltbare Anzeige vorsehen kann.

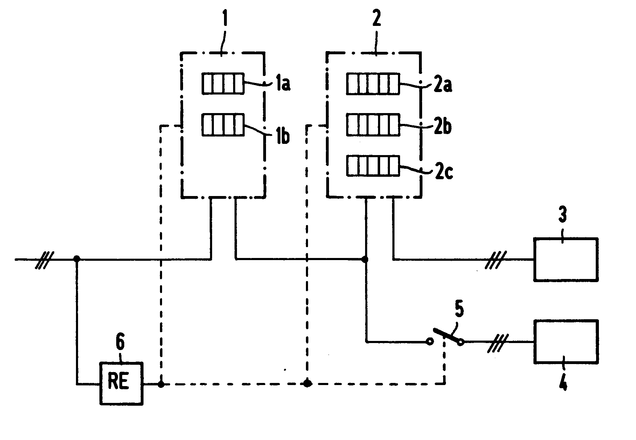

**Patentansprüche**

1. Zähleranordnung mit zwei Zweitarifzählern (1,2) zur getrennten Erfassung des Stromverbrauchs von zwei Verbrauchergruppen (3,4), wobei die zweite Vebrauchergruppe (4) nur während einer ersten Tarifphase betrieben wird, **dadurch gekennzeichnet,** daß die erste Verbrauchergruppe (3) über die Reihenschaltung beider Zweitarifzähler (1,2) und die zweite Verbrauchergruppe (4) nur über einen Zweitarifzähler (1) mit dem Versorgungsnetz verbunden ist und daß durch Vergleich der Zählerstände der beiden Zweitarifzähler (1,2) eine Funktionskontrolle der beiden Zweitarifzähler (1,2) und durch Addition bzw. Subtraktion der Zählerstände eine getrennte Erfassung des Stromverbrauchs der beiden Verbrauchergruppen (3,4) durchgeführt wird.

2. Zähleranordnung nach Anspruch 1, **dadurch gekennzeichnet,** daß der erste Zweitarifzähler (1) ein Ferraris-Zähler und der zweite Zweitarifzähler (2) ein elektronischer Zähler ist.

3. Zähleranordnung nach Anspruch 1, **dadurch gekennzeichnet,** daß beide Zweitarifzähler (1,2) als Elektronikzähler als gemeinsames Gerät mit einer auf die verschiedenen Zählwerke umschaltbaren Anzeige ausgeführt sind.

4. Zähleranordnung nach Anspruch 1, 2 oder 3, **dadurch gekennzeichnet** daß jeder Zähler je ein Hochtarifzählwerk (1a,2a) und ein Niedertarifzählwerk (1b,2b) besitzt,
a) daß der Gesamtverbrauch der ersten Verbrauchergruppe (3) durch Addition der Zählerstände des Hochtarifzählwerks (2a) und des Niedertarifzählwerks (2b) des zweiten Zweitarifzählers (2) ermittelt wird,
b) daß der Gesamtverbrauch der zweiten Verbrauchergruppe (4) durch Differenzbildung der Zählerstände der Niedertarifzählwerke (1b,2b) des ersten und zweiten Zweitarifzählers (1,2) ermittelt wird und
c) daß die Funktionskontrolle durch Vergleich der Zählerstände der Hochtarifzählwerke (1a,2a) des ersten und zweiten Zweitarifzählers (2) erfolgt.

5. Zähleranordnung nach Anspruch 1, 2 oder 3, **dadurch gekennzeichnet** daß der erste Zweitarifzähler ein Hochtarifzählwerk (1a,2a) und ein Niedertarifzählwerk (1b,2b) besitzt und wobei der zweite Zweitarifzähler (2) ein erstes Zählwerk (2a), das sowohl im Hochtarif als auch im Niedertarif arbeitet, und ein zweites Zählwerk (2b) besitzt, das nur im Hochtarif arbeitet,
a) daß der Gesamtverbrauch der ersten Verbrauchergruppe (3) durch den Zählerstand des ersten Zählwerks (2a) des zweiten Zweitarifzählers (2) ermittelt wird,
b) daß der Gesamtverbrauch der zweiten Verbrauchergruppe (4) durch Subtraktion des Zählerstandes des ersten Zählwerks (2a) des zweiten Zweitarifzählers (2) vom Zählerstand des Niedertarifzählwerks (1b) des ersten Zweitarifzählers (1) und Addition des Zählerstandes des zweiten Zählwerks (2b) des zweiten Zweitarifzählers (2) ermittelt wird und
c) daß die Funktionskontrolle durch Vergleich des Zählerstandes des Hochtarifzählwerks (1a) des ersten Zweitarifzählers (1) mit dem Zählerstand des zweiten Zählwerks (2b) des zweiten Zweitarifzählers (2) erfolgt.

6. Zähleranordnung nach Anspruch 1, 2 oder 3, **dadurch gekennzeichnet** daß der erste Zweitarifzähler (1) ein Hochtarifzählwerk (1a) und ein Niedertarifzählwerk (1b) besitzt und wobei der zweite Zweitarifzähler (2) ein erstes Zählwerk (2a), das sowohl im Hochtarif als auch im Niedertarif arbeitet, und ein zweites Zählwerk (2b) besitzt, das nur im Niedertarif arbeitet,

   a) daß der Gesamtverbrauch der ersten Verbrauchergruppe (3) durch den Zählerstand des ersten Zählwerks (2a) des zweiten Zweitarifzählers (2) ermittelt wird,

   b) daß der Gesamtverbrauch der zweiten Verbrauchergruppe (4) durch Differenzbildung der Zählerstände des zweiten Zählwerks (1b) des ersten Zweitarifzählers (1) und des zweiten Zählwerks (2b) des zweiten Zweitarifzählers (2) ermittelt wird,

   c) daß die Funktionskontrolle durch Vergleich des Zählerstandes des ersten Zählwerks (1a) des ersten Zweitarifzählers (1) mit der Differenz der Zählerstände der jeweils zweiten Zählerwerke (1b,2b) des zweiten Zweitarifzählers (2) erfolgt.

**Claims**

1. Meter arrangement with two two-rate meters (1,2) for the separate determination of the current usage of two user groups (3,4), whereby the second user group (4) is only operated during a first rate phase, characterized in that the first user group (3) is connected to the supply network by way of the series connection of both two-rate meters (1,2) and the second user group (4) is only connected to the supply network by way of one two-rate meter (1), and that through comparison of the counts of the two two-rate meters (1,2) a function control of the two two-rate meters (1,2) is carried out and through addition or subtraction of the counts a separate determination of the current usage of the two user groups (3,4) is carried out.

2. Meter arrangement according to claim 1, characterized in that the first two-rate meter (1) is a Ferraris meter and the second two-rate meter (2) is an electronic meter.

3. Meter arrangement according to claim 1, characterized in that both two-rate meters (1,2) are constructed as electronic meters as a common device with a display which can be switched over to the different counting mechanisms.

4. Meter arrangement according to claim 1, 2 or 3, characterized in that each meter has a high-rate counting mechanism (1a,2a) and a low-rate counting mechanism (1b,2b) respectively,

   a) that the total usage of the first user group (3) is determined through addition of the counts of the high-rate counting mechanism (2a) and of the low-rate counting mechanism (2b) of the second two-rate meter (2),

   b) that the total usage of the second user group (4) is determined through differential formation of the counts of the low-rate counting mechanisms (1b,2b) of the first and second two-rate meter (1,2) and

   c) that the function control takes place through comparison of the counts of the high-rate counting mechanisms (1a,2a) of the first and second two-rate meter (2).

5. Meter arrangement according to claim 1, 2 or 3, characterized in that the first two-rate meter has a high-rate counting mechanism (1a,2a) and a low-rate counting mechanism (1b,2b) and whereby the second two-rate meter (2) has a first counting mechanism (2a), which operates both at the high rate and at the low rate, and a second counting mechanism (2b), which only operates at the high rate,

   a) that the total usage of the first user group (3) is determined by means of the count of the first counting mechanism (2a) of the second two-rate meter (2),

   b) that the total usage of the second user group (4) is determined through subtraction of the count of the first counting mechanism (2a) of the second two-rate meter (2) from the count of the low-rate counting mechanism (1b) of the first two-rate meter (1) and addition of the count of the second counting mechanism (2b) of the second two-rate meter (2) and

   c) that the function control takes place through comparison of the count of the high-rate counting mechanism (1a) of the first two-rate meter (1) with the count of the second counting mechanism (2b) of the second two-rate meter (2).

6. Meter arrangement according to claim 1, 2 or 3, characterized in that the first two-rate meter (1) has a high-rate counting mechanism (1a) and a low-rate counting mechanism (1b) and whereby the second two-rate meter (2) has a first counting mechanism (2a), which operates both at the high rate and at the low rate, and a second counting mechanism (2b), which only operates at the low rate,

   a) that the total usage of the first user group (3) is determined by means of the count of the first counting mechanism (2a) of the second two-rate meter (2),

b) that the total usage of the second user group (4) is determined through differential formation of the counts of the second counting mechanism (1b) of the first two-rate meter (1) and of the second counting mechanism (2b) of the second two-rate meter (2),

c) that the function control takes place through comparison of the count of the first counting mechanism (1a) of the first two-rate meter (1) with the difference of the counts of each of the second counting mechanisms (1b,2b) of the second two-rate meter (2).

**Revendications**

1. Dispositif de comptage comportant deux compteurs à deux tarifs (1,2) permettant de déterminer séparément la consommation de courant de deux groupes de consommateurs (3,4), le second groupe de consommateurs (4) fonctionnant uniquement pendant la première tranche tarifaire, caractérisé par le fait que le premier groupe de consommateurs (3) est raccordé par l'intermédiaire du circuit série formé des deux compteurs à deux tarifs (1,2) et que le second groupe de consommateurs (4) est raccordé uniquement par l'intermédiaire d'un compteur à deux tarifs (1) au réseau d'alimentation et qu'un contrôle de fonctionnement des deux compteurs à deux tarifs (1,2) est réalisé par comparaison des états de comptage des deux compteurs à deux tarifs (1,2) et qu'une détermination séparée de la consommation de courant des deux groupes de consommateurs (3,4) est exécutée par addition ou soustraction des états de comptage des compteurs.

2. Dispositif de comptage suivant la revendication 1, caractérisé par le fait que le premier compteur à deux tarifs (1) est un compteur Ferraris et que le second compteur à deux tarifs (2) est un compteur électronique.

3. Dispositif de comptage suivant la revendication 1, caractérisé par le fait que les deux compteurs à deux tarifs (1,2) sont réalisés sous la forme de compteurs électroniques en tant qu'appareil commun avec un affichage commutable sur les différents mécanismes de comptage.

4. Dispositif de comptage suivant la revendication 1, 2 ou 3, caractérisé par le fait que chaque compteur possède respectivement un mécanisme de comptage à tarif élevé (1a,2a) et un mécanisme de comptage à tarif faible (1b,2b),

a) que la consommation totale du premier groupe de consommateurs (3) est déterminée par addition des états de comptage du mécanisme de comptage à tarif élevé (2a) et du mécanisme de comptage à tarif faible (2b) du second compteur à deux tarifs (2),

b) que la consommation totale du second groupe de consommateurs (4) est déterminée par formation de la différence des états de comptage des mécanismes de comptage à tarif faible (1b,2b) des premier et second compteurs à deux tarifs (1,2), et

c) que le contrôle de fonctionnement est exécuté par comparaison des états de comptage des mécanismes de comptage à tarif élevé (1a,2a) des premier et second compteurs à deux tarifs (2).

5. Dispositif de comptage suivant la revendication 1, 2 ou 3, caractérisé par le fait que le premier compteur à deux tarifs possède un mécanisme de comptage à tarif élevé (1a,2a) et un mécanisme de comptage à tarif faible (1b,2b) comportant un premier mécanisme de comptage (2a), qui travaille aussi bien avec le tarif élevé qu'avec le tarif faible, et un second mécanisme de comptage (2b) qui travaille uniquement avec le tarif élevé, et

a) que la consommation totale du premier groupe de consommateurs (3) est déterminée par l'état de comptage du premier mécanisme de comptage (2a) du second compteur à deux tarifs (2),

b) que la consommation totale du second groupe de consommateurs (4) est déterminée par soustraction de l'état de comptage du premier mécanisme de comptage (2a) du second compteur à deux tarifs (2), de l'état de comptage du mécanisme de comptage à tarif faible (1b) et du premier compteur à deux tarifs (1) et addition de l'état de comptage du second mécanisme de comptage (2b) du second compteur à deux tarifs (2), et

c) que le contrôle de fonctionnement est exécuté au moyen d'une comparaison entre l'état de comptage du mécanisme de comptage à tarif élevé (1a) du premier compteur à deux tarifs (1) et l'état de comptage du second mécanisme de comptage (20) du second compteur à deux tarifs (2).

6. Dispositif de comptage suivant la revendication 1, 2 ou 3, caractérisé par le fait que le premier compteur à deux tarifs possède un mécanisme de comptage à tarif élevé (1a,2a) et un mécanisme de comptage à tarif faible (1b,2b) comportant un premier mécanisme de comptage (2a), qui travaille aussi bien avec le tarif élevé qu'avec le tarif faible, et un second mécanisme de comptage (2b) qui travaille uniquement avec le tarif élevé, et

a) que la consommation totale du premier groupe de consommateurs (3) est déterminée par l'état de comptage du premier mécanisme de comptage (2a) du second compteur à deux tarifs (2),

b) que la consommation totale du second groupe de consommateurs (4) est déterminée par formation de la différence des états de comptage du second mécanisme de comptage (1b) du premier compteur à deux tarifs (1) et du second mécanisme de comptage (2b) du second compteur à deux tarifs (2),

c) que le contrôle de fonctionnement est exécuté par comparaison entre l'état de comptage du premier mécanisme de comptage (1a) du premier compteur à deux tarifs (1) et la différence des états de comptage des seconds mécanismes de comptage (1b,2b) du second compteur à deux tarifs (2).